# EUROPÄISCHE PATENTANMELDUNG

(11) **EP 3 852 145 A1**
(43) Veröffentlichungstag der Anmeldung: **21.07.2021**
(21) Anmeldenummer: 20152041.8
(22) Anmeldetag: 15.01.2020
(51) Int. Cl.: H01L 27/30, H01L 51/42, H02S 50/00, H02S 50/10

(54) **ABKOPPELUNG EINER PEROWSKIT-SOLARZELLE BEI DUNKELHEIT**

(71) Anmelder: Siemens Aktiengesellschaft, 80333 München (DE)
(72) Erfinder: Fleischer, Maximilian, 85635 Höhenkirchen (DE); Pohle, Roland, 85570 Herdweg (DE); Simon, Elfriede, 80639 München (DE); von Sicard, Oliver, 81541 München (DE)

(57) **Zusammenfassung**

Die Erfindung betrifft ein Verfahren zum Betreiben eines Photovoltaikmoduls (10). Das Photovoltaikmodul (10) weist zumindest eine Perowskit-Solarzelle (11) auf. Das Verfahren umfasst das zeitweilige Betreiben des Photovoltaikmoduls (10) am Punkt maximaler Leistung mittels einer mit dem Photovoltaikmodul (10) verbundenen Regelungseinrichtung (20), wobei die Entnahme elektrischer Energie unterbrochen wird, wenn die Bestrahlungsstärke einer auf das Photovoltaikmodul (10) auftreffenden elektromagnetischen Strahlung (2) einen vorbestimmten Schwellwert unterschreitet.

Die Erfindung betrifft des Weiteren eine Photovoltaik-Einrichtung (1) umfassend ein Photovoltaikmodul (10) mit zumindest einer Perowskit-Solarzelle (11) und eine mit dem Photovoltaikmodul (10) verbundener Regelungseinrichtung (20).

## Beschreibung

### Technisches Gebiet

Die Erfindung betrifft ein Verfahren zum Betreiben eines Photovoltaikmoduls aufweisend zumindest eine Perowskit-Solarzelle. Des Weiteren betrifft die Erfindung eine Photovoltaik-Einrichtung umfassend ein Photovoltaikmodul mit zumindest einer Perowskit-Solarzelle und eine mit dem Photovoltaikmodul verbundene Regelungseinrichtung.

### Stand der Technik

Photovoltaikmodule werden in einer Photovoltaikanlage typischerweise mittels Maximum Power Point Tracking (MPPT) betrieben. Dies ist ein elektrotechnisches Verfahren, bei dem die elektrische Belastung des Photovoltaikmoduls so geregelt wird, dass die maximale Leistung aus dem Photovoltaikmodul entnommen wird. Der optimale Betriebspunkt des Photovoltaikmoduls ist zeitlich nicht konstant, sondern hängt von Parametern wie beispielsweise der Bestrahlungsstärke, des Bestrahlungsspektrums und der Temperatur der Solarzellen des Photovoltaikmoduls ab. Auch der Typ der verwendeten Solarzellen (z.B. monokristallines/multikristallines/amorphes Silicium) hat Einfluss darauf, wo sich der optimale Betriebspunkt befindet. Der optimale Betriebspunkt wird in der Regel fortlaufend nachgeregelt.

Maximum Power Point Tracking ist für Photovoltaikmodule mit kristallinen Silicium-Solarzellen ein etabliertes Verfahren zur Maximierung der entnommenen Leistung.

Um das Maximum Power Point Tracking Verfahren für ein Photovoltaikmodul durchzuführen, ist typischerweise eine Regelungseinrichtung mit dem Photovoltaikmodul (oder einem Strang von Photovoltaikmodulen) verbunden. Die Regelungseinrichtung gibt einen Widerstand vor, der auch als Lastwiderstand bezeichnet wird. Der Lastwiderstand wird so eingestellt, dass er demjenigen Innenwiderstand des Photovoltaikmoduls entspricht, bei dem die Leistung des Photovoltaikmoduls maximal ist. Das Photovoltaikmodul wird dabei hinsichtlich der Regelungseinrichtung mit Leistungsanpassung betrieben.

Eine Herausforderung des MPPT-Verfahrens besteht darin, zuverlässig und mit möglichst geringem Energieaufwand den optimalen Betriebspunkt zu ermitteln. Dies ist z.B. bei teilweiser Verschattung der Photovoltaikanlage nicht trivial, da hier unter Umständen nur ein lokales anstatt das globale Leistungsmaximum von der Regelungseinrichtung ermittelt wird. Entsprechende Lösungsansätze für die möglichst zuverlässige Ermittlung des globalen Leistungsmaximums eines Photovoltaikmoduls oder einer Photovoltaikanlage werden beispielsweise in den Patentschriften EP 1 750 193 B1 oder EP 2 360 546 B1 offenbart.

In jedem Fall ist das Photovoltaikmodul aber durchgängig mit der Regelungseinrichtung zu verbinden, um auch bei diffuser Solarstrahlung auf das Photovoltaikmodul, z.B. bei Bewölkung oder Dämmerung, noch die maximale elektrische Leistung zu entnehmen. Nachts bleibt das Photovoltaikmodul mit der Regelungseinrichtung verbunden, auch wenn bei völliger Dunkelheit dem Photovoltaikmodul keine Leistung entnehmbar ist.

Seit einigen Jahren werden Perowskite, wie z.B. CH₃NH₃PbI₃, hinsichtlich ihrer Verwendbarkeit in Solarzellen untersucht. Aufgrund ihrer optoelektronischen Eigenschaften erlauben sie im Prinzip eine hocheffiziente Umwandlung von elektromagnetischer Strahlungsenergie in elektrische Energie. Perowskitbasierte Solarzellen, im Folgenden auch als Perowskit-Solarzellen bezeichnet, zeichnen sich zum einen dadurch aus, dass sie vergleichsweise kostengünstig in der Herstellung sind. Zum anderen stellen Perowskit-Solarzellen eine attraktive und ernstzunehmende Alternative zu herkömmlichen siliziumbasierten Solarzellen dar, weil sich aufgrund der in den letzten Jahren rasant erzielten Fortschritte hinsichtlich ihres Wirkungsgrades von einigen wenigen Prozent auf heutzutage über 25% andeutet, dass Wirkungsgrade erreichbar sind, die diejenigen herkömmlicher Silicium-Solarzellen signifikant übertreffen. Dabei ist es denkbar, eine Perowskit-Solarzelle allein oder aber in einem Tandem-Photovoltaik-Modul bspw. in Kombination mit einer kristallinen Silicium-Solarzelle zu betreiben.

Photovoltaikmodule mit Perowskit-Solarzellen sind derzeit zumindest kommerziell noch nicht erhältlich. Dementsprechend gibt es auch über den optimalen Betrieb eines Photovoltaikmoduls mit Perowskit-Solarzellen noch keine Erkenntnisse.

Die vorliegende Erfindung hat sich vor diesem Hintergrund die Aufgabe gestellt, ein Konzept zu entwickeln, ein effizientes Betriebsverfahren für den Betrieb eines Photovoltaikmoduls, das eine oder mehrere Perowskit-Solarzellen enthält, zu entwickeln.

### Allgemeine Beschreibung der Erfindung

Im Rahmen eigener Untersuchungen hat die Anmelderin überraschenderweise festgestellt, dass Perowskit-Solarzellen stark degradieren, wenn sie ohne Beleuchtung, z.B. nachts, über einen längeren Zeitraum mittels MPPT belastet werden. Selbst bei Beleuchtung mit nur geringer Intensität konnte unter gewissen Umständen eine Degradation gemessen werden.

Die Gründe für die Degradation eines mittels Maximum Power Point Tracking bei geringer oder nicht vorhandener Beleuchtung betriebenen Photovoltaikmoduls, welches eine oder mehrere Perowskit-Solarzellen enthält, sind derzeit noch unklar. Die physikalischen/chemischen Effekte, die zu der beobachteten Degradation führen, sind derzeit noch nicht zweifelsfrei geklärt.

Ein deutlich verbessertes Verfahren für den Betrieb eines Photovoltaikmoduls, das eine oder mehrere Perowskit-Solarzellen enthält, stellt erfindungsgemäß jedoch das folgende Verfahren dar: Das Verfahren umfasst das zumindest zeitweilige Betreiben des Photovoltaikmoduls am Punkt maximaler Leistung mittels einer mit dem Photovoltaikmodul verbundenen Regelungseinrichtung. Die Entnahme elektrischer Energie wird dabei unterbrochen, wenn die Bestrahlungsstärke einer auf das Photovoltaik auftreffenden elektromagnetischen Strahlung einen vorbestimmten Schwellwert unterschreitet.

Selbstverständlich weist das Perowskit-Photovoltaikmodul in der Regel mehr als eine Perowskit-Solarzelle, nämlich eine Vielzahl von Perowskit-Solarzellen, auf. Eine Perowskit-Solarzelle kann auch Teil einer Tandemzelle sein, die aus einer Perowskit-Solarzelle und einer weiteren Solarzelle, beispielsweise einer konventionellen Silicium-Solarzelle, aufgebaut ist. Für derartige Tandemsolarzellen sind im Labormaßstab kürzlich beeindruckende 28% Wirkungsgrad erreicht worden.

Das Photovoltaikmodul wird insbesondere im Wesentlichen während des gesamten Zeitraums, in dem die Bestrahlungsstärke den vorbestimmten Schwellwert überschreitet, mittels der Regelungseinrichtung am Punkt der maximalen Leistung betrieben.

Dies bedeutet, dass das Photovoltaikmodul vorteilhafterweise dann, wenn die Bestrahlungsstärke den vorbestimmten Schwellwert überschreitet, mittels der Regelungseinrichtung am Punkt der maximalen Leistung betrieben wird und die Energieentnahme dann, wenn die Bestrahlungsstärke den vorbestimmten Schwellwert unterschreitet, unterbrochen wird.

Bei der Regelungseinrichtung handelt es sich insbesondere um einen dem Photovoltaikmodul zugeordneten Wechselrichter, der insbesondere mit einem einstellbaren Lastwiderstand ausgestattet ist. Hierbei kann der Wechselrichter einem einzelnen Photovoltaikmodul zugeordnet sein (ein solcher Wechselrichter wird in der Fachsprache auch als Mikroinverter oder Micro-Inverter bezeichnet) oder einem ganzen Strang (engl.: string) von Photovoltaikmodulen. Theoretisch ist auch ein individueller Wechselrichter pro Solarzelle denkbar.

Da die Belastung des Photovoltaikmoduls anhand der Belastungsspannung eingestellt wird, die Ausgangsspannung der Regelungseinrichtung jedoch nahezu konstant sein soll, wird in der Regel ein Gleichspannungswandler eingesetzt, um die Spannungsdifferenzen und somit die Belastung der Solarzelle einstellen zu können. Das kontinuierliche Nachregeln des optimalen Betriebspunkts des Photovoltaikmoduls (nämlich das Betreiben des Photovoltaikmoduls am Punkt maximaler Leistung) wird vorteilhafterweise konkret von einem Mikrocontroller oder einem digitalen Signalprozessor durchgeführt. Dabei können dem Prozessor die benötigten Messdaten von einem Analogdigital-Umsetzer zur Verfügung gestellt werden. Der Analogdigital-Umsetzer kann dann die nötigen Berechnungen durchführen und das Ergebnis mittels Pulsweitenmodulation an den Gleichspannungswandler weitergeben.

Die Regelungseinrichtung kann auch in einem dem Photovoltaikmodul zugeordneten sogenannten "Leistungsoptimierer" (engl. "power optimizer") bestehen.

Erfindungsgemäß wird die Entnahme elektrischer Energie unterbrochen, wenn die Bestrahlungsstärke der auf das Photovoltaikmodul auftreffenden elektromagnetischen Strahlung einen vorbestimmten Schwellwert unterschreitet. Unter der Entnahme elektrischer Energie wird die Entnahme elektrischer Energie vom Photovoltaikmodul verstanden. Diese Entnahme wird bei angeschlossener Regelungseinrichtung durch die Regelungseinrichtung gesteuert, und zwar dergestalt, dass die Menge der entnommenen Energie idealerweise immer größtmöglich ist.

In einer ersten Variante wird das Photovoltaikmodul bei Unterschreiten des vorbestimmten Schwellwerts der Bestrahlungsstärke von der Regelungseinrichtung elektrisch abgekoppelt. Der Stromkreis, an dem das Photovoltaikmodul hängt, ist demnach offen und es liegt am Photovoltaikmodul die Leerlaufspannung (englisch: open circuit voltage) an.

Die Abkoppelung bzw. das Trennen des Photovoltaikmoduls von der Regelungseinrichtung kann in der Praxis einfach durch eine Trennung des elektrischen Kontakts (in anderen Worten eine elektrische Isolierung) der Regelungseinrichtung von dem Photovoltaikmodul realisiert werden. Hierfür kann beispielsweise ein entsprechender Schalter oder ein entsprechendes Relais geöffnet bzw. geschlossen werden. Alternativ kann die zeitweilige Trennung des Photovoltaikmoduls von der Regelungseinrichtung auch elektronisch erfolgen, beispielsweise mittels eines Transistors, der hochohmig gesteuert wird. Wird z.B. ein Metall-Oxid-Halbleiter-Feldeffekttransistor (englisch: metal-oxide-semiconductor field-effect transistor, MOSFET) verwendet, müsste für die Steuerung des Transistors keine nennenswerte Energie aufgewendet werden. Die Verwendung eines Transistors hat gegenüber der Verwendung eines mechanischen Schalters den Vorteil, dass keine beweglichen Teile involviert sind und er somit wartungsfrei und langlebig ist. Da dem Photovoltaikmodul bei Aktivierung des Schalters/Transistors keine elektrische Spannung entnommen werden kann, ist auch die entnehmbare elektrische Leistung aus dem Photovoltaikmodul (bzw. entsprechend die entnehmbare elektrische Energie) gleich Null.

In einer zweiten Variante wird bei Unterschreiten des vorbestimmten Schwellwerts der Bestrahlungsstärke das Photovoltaikmodul elektrisch kurzgeschlossen. Auch dies kann durch einen entsprechenden Schalter, Relais oder Transistor realisiert werden, der in diesem Fall die beiden elektrischen Kontakte (Vorder- und Rückseitenkontakt bzw. p-/n-Kontakt) des Photovoltaikmoduls elektrisch leitend verbindet. Da dem Photovoltaikmodul in diesem Fall kein elektrischer Stromfluss entnommen werden kann, ist auch hier die entnehmbare elektrische Leistung (bzw. entsprechend die elektrische Energie) gleich Null.

Erfindungsgemäß wird die Entnahme elektrischer Energie unterbrochen, wenn die Bestrahlungsstärke kleiner als ein vorbestimmter Schwellwert ist. Dieser Schwellwert liegt insbesondere im Bereich 2 W/m² und 20 W/m², vorzugsweise zwischen 5 W/m² und 15 W/m² und besonders bevorzugt bei 10 W/m². Ein Schwellwert in einem dieser Bereiche entspricht einer schwachen bzw. sehr schwachen Beleuchtung der Perowskit-Solarzelle(n). Die Festlegung des Schwellwerts in einem dieser Bereiche ist deswegen vorteilhaft, weil die Degradierung der Perowskit-Solarzelle, insbesondere die Reduktion ihres Wirkungsgrads, gerade bei keiner bzw. (sehr) schwachen Beleuchtung in Verbindung mit einer angeschlossenen MPPT-Regelungseinrichtung beobachtet wurde.

Unter der Bestrahlungsstärke wird die gesamte Leistung der eingehenden elektromagnetischen Energie, die auf eine Oberfläche trifft, bezogen auf die Größe der Fläche, verstanden. Die Bestrahlungsstärke ist also in anderen Worten der Strahlungsfluss durch die bestrahlte Fläche. Sie wird auch als Strahlungsflussdichte oder Strahlungsstromdichte (engl.: "irradiance" oder "radiant flux density") bezeichnet.

Als Maß für die Bestrahlungsstärke der auf das Photovoltaikmodul auftreffenden elektromagnetischen Strahlung kann beispielsweise der von dem Photovoltaikmodul erzeugte Photostrom herangezogen werden. Dies hat den Vorteil, dass der Photostrom ohnehin in aller Regel messtechnisch erfasst wird und somit als Regelungsgröße bezüglich der Abtrennung bzw. des elektrischen Verbindens der Regelungseinrichtung von dem Photovoltaikmodul geeignet erscheint. Als Maß für die Bestrahlungsstärke könnte anstatt des Photostroms unter Umständen (bei bekannter und zeitlich stabiler Moduleffizienz) auch die Ausgangsleitung des Photovoltaikmoduls herangezogen werden.

Alternativ kann die Bestrahlungsstärke auch mittels Impedanzspektroskopie an einer oder, falls vorhanden, mehreren Perowskit-Solarzellen des Photovoltaikmoduls bestimmt werden. Bei der Impedanzspektroskopie, insbesondere der elektrochemischen Impedanzspektroskopie, wird eine Wechselspannung an die Perowskit-Solarzelle angelegt und für verschiedene Frequenzen der Wechselspannung der resultierende Stromfluss gemessen. Basierend auf einer geeigneten Auftragung der Messergebnisse, beispielsweise in einem sogenannten Bode- oder Nyquist-Diagramm, können anschließend Rückschlüsse auf interne Parameter der Perowskit-Solarzelle gezogen werden, z.B. Ladungsträgertransport oder Rekombinationsrate der Ladungsträger. Mittels der Werte geeigneter interner Parameter kann insbesondere auch auf die Bestrahlungsstärke der untersuchten Solarzelle geschlossen werden.

Eine weitere Möglichkeit, die Bestrahlungsstärke der auf das Photovoltaikmodul auftreffenden elektromagnetischen Strahlung zu bestimmen, ist das Vorsehen einer zusätzlichen Photozelle, mittels derer die Bestrahlungsstärke bestimmt wird. Konkret kann die Bestrahlungsstärke in diesem Fall beispielsweise mittels des von der zusätzlichen Photozelle erzeugten Photostroms bestimmt werden.

Die zusätzliche Photozelle kann relativ klein dimensioniert sein (z.B. 1 x 1 cm²) und ist vorteilhafterweise in das Photovoltaikmodul integriert. Sie kann beispielsweise im Rahmen, also am Rand des Photovoltaikmoduls, integriert sein.

Noch eine weitere Möglichkeit, die Bestrahlungsstärke der auf das Photovoltaikmodul auftreffenden solaren Strahlung einzuschätzen, ist der Rückgriff auf meteorologischen Daten. Sonnenaufgang und Sonnenuntergang für einen bestimmten Standort auf der Erde im Jahreslauf (also für jeden Tag) sind bekannt und können nach Kenntnis des Standorts des Photovoltaikmoduls in der Regelungseinrichtung beispielsweise einprogrammiert werden. Dies hat den Vorteil, dass keine Messdaten zur Regelung bezüglich Abtrennens oder Verbindens der Regelungseinrichtung erhoben und verarbeitet werden müssen. Allerdings ist ein solches Verfahren auch weniger präzise, da Bewölkung bzw. Verschattung des Photovoltaikmoduls oder eines Teils davon damit nicht erfasst und berücksichtigt werden kann.

Schließlich kann die erfinderische Idee auch in einer Photovoltaik-Einrichtung umgesetzt sein. Die Photovoltaik-Einrichtung umfasst ein Photovoltaikmodul mit zumindest einer Perowskit-Solarzelle sowie eine mit dem Photovoltaikmodul verbundene Regelungseinrichtung. Die Regelungseinrichtung ist dazu ausgestaltet, das Photovoltaikmodul zumindest zeitweilig am Punkt maximaler Leistung zu betreiben, aber die Energieentnahme zu unterbrechen, wenn die Bestrahlungsstärke einer auf das Photovoltaik auftreffenden elektromagnetischen Strahlung einen vorbestimmten Schwellwert unterschreitet.

### Kurze Beschreibung der Zeichnungen

Nachfolgend wird die Erfindung anhand der beigefügten Abbildungen veranschaulicht.

Die Abbildungen zeigen:
- Fig. 1:: ein Photovoltaikmodul, das von einer Regelungseinrichtung elektrisch abgekoppelt ist, so dass die Entnahme elektrischer Energie unterbrochen ist,
- Fig. 2:: dasselbe Photovoltaikmodul, das nun mit der Regelungseinrichtung elektrisch verbunden ist, so dass das Photovoltaikmodul am Punkt maximaler Leistung betrieben werden kann,
- Fig. 3:: dasselbe Photovoltaikmodul, das nun kurzgeschlossen ist und
- Fig. 4:: die zeitlichen Entwicklungen der Wirkungsgrade zweier Perowskit-Solarzellen.

### Detaillierte Beschreibung der Zeichnungen

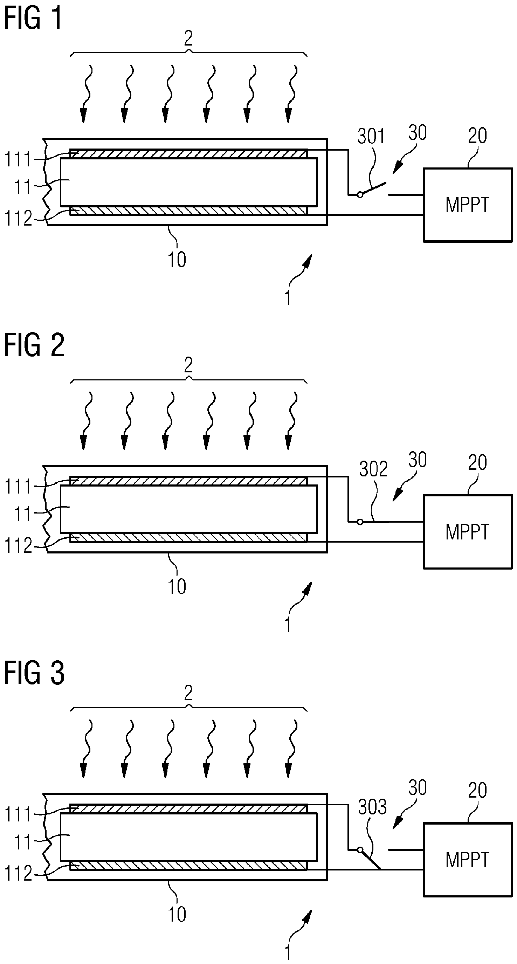

Die Abbildungen 1 bis 3 (auch als Fig. 1 bis 3 bezeichnet) zeigen ein Ausführungsbeispiel einer erfindungsgemäßen Photovoltaik-Einrichtung 1. Die Photovoltaik-Einrichtung 1 weist ein Photovoltaikmodul 10 mit einer Vielzahl von Perowskit-Solarzellen 11 auf, von denen in Abbildung 1 der Übersicht halber nur eine gezeigt ist. Jeder der Perowskit-Solarzellen 11 weist eine elektronleitende Schicht, eine lichtabsorbierende Schicht (auch "Absorber" genannt) und eine lochleitende Schicht auf. Der Absorber enthält einen Perowskiten mit der allgemeinen Strukturformel ABX₃, wobei beispielsweise A=CH₃NH₃, B=Pb und X=I₃. Des Weiteren weist die Solarzelle einen Vorderseitenkontakt 111 und einen Rückseitenkontakt 112 auf. Der Vorderseitenkontakt 111 ist für elektromagnetische Strahlung aus einem bestimmten Wellenlängenbereich, für den die Solarzelle konzipiert ist, vorzugsweise transparent. Der Rückseitenkontakt kann vollflächig und nicht transparent ausgestaltet sein (z.B. umfassend eine Aluminiumlegierung). Die Perowskit-Solarzellen 11 sind in Glasscheiben eingebettet, die sie z.B. vor Verschmutzung und Beschädigung schützen sollen.

Die Abbildungen 1 bis 3 zeigen auch elektromagnetische Strahlung 2 der Sonne, auch als "solare Strahlung" bezeichnet, die auf die Vorderseite des Photovoltaikmoduls 10 und damit auch auf die Vorderseite der Perowskit-Solarzelle 11 trifft.

Die Vorder- und Rückseitenkontakte 111, 112 der in Abbildung 1 gezeigten Solarzelle 11 sind elektrisch leitend mit einer Regelungseinrichtung 20 verbindbar. Das Photovoltaikmodul 10 kann nämlich mittels eines Schalters 30 mit der Regelungseinrichtung 20 elektrisch verbunden oder von dieser elektrisch abgekoppelt sein. Zusätzlich kann mittels des Schalters 30 das Photovoltaikmodul 10 auch kurzgeschlossen werden.

In Abbildung 1 ist eine erste Stellung 301 des Schalters 30 skizziert. In der ersten Stellung 301 ist der Schalter geöffnet und das Photovoltaikmodul 10 ist von der Regelungseinrichtung 20 elektrisch getrennt. Am Photovoltaikmodul 10 liegt demzufolge Leerlaufspannung (englisch: open circuit voltage) an. Es wird dem Photovoltaikmodul 10 keine Energie entnommen.

In Abbildung 2 ist eine zweite Stellung 302 des Schalters 30 skizziert. In der zweiten Stellung 302 ist der Schalter geschlossen und die elektrische Verbindung zwischen dem Photovoltaikmodul 10 und der Regelungseinrichtung 20 ist hergestellt. Die Regelungseinrichtung 20 ist imstande, durch Anpassung ihres Lastwiderstands auf den aktuell vorliegenden Innenwiderstand des Photovoltaikmoduls die maximale Leistung (bzw. entsprechend die maximale Energie) dem Photovoltaikmodul zu entnehmen.

In Abbildung 3 ist eine dritte Stellung 303 des Schalters 30 skizziert. In der dritten Stellung 303 verbindet der Schalter den Vorderseitenkontakt 111 und Rückseitenkontakt 112 des Photovoltaikmoduls 10 und schließt dieses somit kurz. Am Photovoltaikmodul 10 fließt ein entsprechender Kurzschlussstrom (englisch: short circuit) und dem Photovoltaikmodul 10 kann auch keine Energie entnommen werden.

Insbesondere kann die Regelungseinrichtung 20 selbst den Schalter 30 in die jeweils passende Stellung 301, 302, 303 versetzen. Bei ausreichend großer Bestrahlungsstärke wird der Schalter geschlossen (Stellung 302) und es erfolgt Maximum Power Point Tracking des Photovoltaikmoduls 10. Unterschreitet die Bestrahlungsstärke jedoch einen vorbestimmten Schwellwert, wird das Photovoltaikmodul 10 entweder von der Regelungseinrichtung abgekoppelt (Stellung 301) oder kurzgeschlossen. In beiden Fällen ist die Folge, dass kein Maximum Power Point Tracking des Photovoltaikmoduls mittels der Regelungseinrichtung 20 mehr möglich ist, und somit eine Degradation der Perowskit-Solarzelle(n) 11 des Photovoltaikmoduls 10 verhindert oder zumindest reduziert wird.

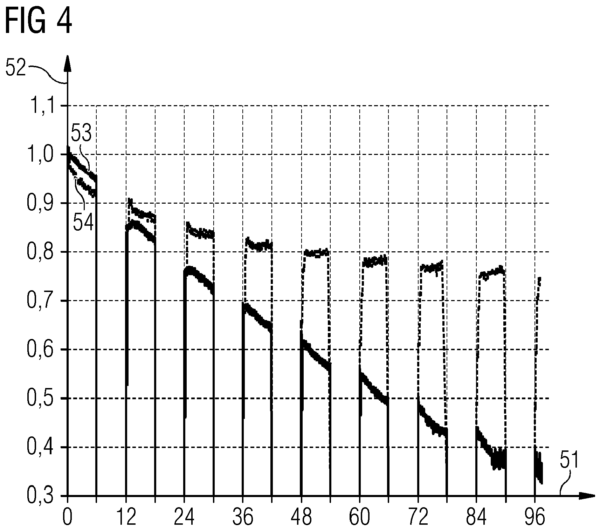

Die Abbildung 4 (auch als Fig. 4 bezeichnet) zeigt den zeitlichen Verlauf des Wirkungsgrads einer ersten Perowskit-Solarzelle 53 und den zeitlichen Verlauf des Wirkungsgrads einer zweiten Perowskit-Solarzelle 54. Auf der Abszisse 51 ist die Zeit in Stunden, auf der Ordinate 52 ist der normierte Wirkungsgrad aufgetragen. Der Wirkungsgrad ist normiert aufgetragen, das heißt, er wurde für beide Solarzellen zu Beginn der Messungen auf den relativen Wert 1,0 gesetzt. Beide Solarzellen sind bezüglich Aufbau, Material und Leistung vergleichbar. Beide Solarzellen wurden künstlich jeweils sechs Stunden beleuchtet, jeweils unterbrochen von einem sechsstündigen Zeitraum in Dunkelheit. Dies sollte den Tag-/Nachtrhythmus zeitlich gestrafft simulieren. Die Beleuchtung entsprach bezüglich Intensität und Spektrum beispielhaft einer realen Beleuchtung mit Sonnenlicht.

Die erste Solarzelle war während des gesamten Messzeitraums von 100 Stunden (ca. 8 Tag-/Nachtzyklen) mit einer konventionellen Regelungseinrichtung zum Betreiben der Solarzelle am Punkt maximaler Leistung, also einer sogenannten "Maximum Power Point Tracking Regelungseinrichtung" verbunden. Insbesondere war die Solarzelle auch während der Dunkelperioden mit der genannten Regelungseinrichtung verbunden bzw. "belastet".

Dies führte im Ergebnis zu einer beträchtlichen Degradation des Wirkungsgrads der untersuchten Solarzelle. Am Ende des 100-stündigen Messzeitraums betrug der Wirkungsgrad der Solarzelle nur noch ca. ein Viertel von dem Wert zu Beginn der Untersuchungen.

Die zweite Solarzelle wurde während der Zeiträume, während der die Zelle Dunkelheit ausgesetzt war (8 x 6 Stunden), von der "Maximum Power Point Tracking Regelungseinrichtung" getrennt. Auch hier ist zum einen eine gewisse Degradation des Zellwirkungsgrads während der Hellphasen und zum anderen eine gewisse Degradation des Wirkungsgrads während der Dunkelzeiten zu beobachten. Die Degradation fiel jedoch deutlich geringer im Vergleich zu der permanent mit der Regelungseinrichtung verbundenen ersten Solarzelle aus. Am Ende des 100-stündigen Messzeitraums betrug der Wirkungsgrad der Solarzelle immerhin noch ca. drei Viertel von dem Wert zu Beginn der Untersuchungen.

Das Trennen eines Photovoltaikmoduls mit einer Perowsit-Solarzelle von der MPPT-Regelungseinrichtung während Dunkelheit (oder schwacher Beleuchtung) kann somit die Degradation der Perowskit-Solarzelle zumindest abmildern, eventuell auch gänzlich beheben oder zumindest begrenzen.

### Bezugszeichenliste

- 1: Photovoltaik-Einrichtung
- 2: Elektromagnetische Strahlung
- 10: Photovoltaikmodul
- 11: Perowskit-Solarzelle
- 111: Vorderseitenkontakt
- 112: Rückseitenkontakt
- 20: Regelungseinrichtung
- 30: Schalter
- 301: Erste Stellung
- 302: Zweite Stellung
- 303: Dritte Stellung
- 51: Abszisse
- 52: Ordinate
- 53: Wirkungsgrad einer ersten Perowskit-Solarzelle
- 54: Wirkungsgrad einer zweiten Perowskit-Solarzelle

## Patentansprüche

1. Verfahren zum Betreiben eines Photovoltaikmoduls (10) aufweisend zumindest eine Perowskit-Solarzelle (11), das Verfahren umfassend das zumindest zeitweilige Betreiben des Photovoltaikmoduls (10) am Punkt maximaler Leistung mittels einer mit dem Photovoltaikmodul (10) verbundenen Regelungseinrichtung (20), wobei die Entnahme elektrischer Energie unterbrochen wird, wenn die Bestrahlungsstärke einer auf das Photovoltaikmodul (10) auftreffenden elektromagnetischen Strahlung (2) einen vorbestimmten Schwellwert unterschreitet.

2. Verfahren nach Anspruch 1,
wobei das Photovoltaikmodul (10) im Wesentlichen während des gesamten Zeitraums, in dem die Bestrahlungsstärke den vorbestimmten Schwellwert überschreitet, mittels der Regelungseinrichtung (20) am Punkt der maximalen Leistung betrieben wird.

3. Verfahren nach einem der vorhergehenden Ansprüche,
wobei bei Unterschreiten des vorbestimmten Schwellwerts der Bestrahlungsstärke das Photovoltaikmodul (10) von der Regelungseinrichtung (20) elektrisch abgekoppelt wird.

4. Verfahren nach einem der Ansprüche 1 oder 2,
wobei bei Unterschreiten des vorbestimmten Schwellwerts der Bestrahlungsstärke das Photovoltaikmodul (10) kurzgeschlossen wird.

5. Verfahren nach einem der vorhergehenden Ansprüche,
wobei der vorbestimmte Schwellwert im Bereich zwischen 2 W/m² und 20 W/m², insbesondere zwischen 5 W/m² und 15 W/m², besonders bevorzugt bei 10 W/m² liegt.

6. Verfahren nach einem der vorhergehenden Ansprüche,
wobei als Maß für die Bestrahlungsstärke der auf das Photovoltaikmodul (10) auftreffenden elektromagnetischen Strahlung (2) der von dem Photovoltaikmodul (10) erzeugte Photostrom herangezogen wird.

7. Verfahren nach einem der vorhergehenden Ansprüche,
wobei die Bestrahlungsstärke der auf das Photovoltaikmodul (10) auftreffenden elektromagnetischen Strahlung (2) mittels Impedanzspektroskopie an einer oder mehreren Perowskit-Solarzellen (11) des Photovoltaikmoduls (10) bestimmt wird.

8. Verfahren nach einem der vorhergehenden Ansprüche,
wobei das Photovoltaikmodul (10) eine zusätzliche Photozelle aufweist und die Bestrahlungsstärke der auf das Photovoltaikmodul (10) auftreffenden elektromagnetischen Strahlung (2) mittels der zusätzlichen Photozelle bestimmt wird.

9. Verfahren nach Anspruch 8,
wobei die Bestrahlungsstärke mittels des von der zusätzlichen Photozelle erzeugten Photostroms bestimmt wird.

10. Verfahren nach einem der vorhergehenden Ansprüche,
wobei die Bestrahlungsstärke der auf das Photovoltaikmodul (10) auftreffenden elektromagnetischen Strahlung (2) basierend auf meteorologischen Daten geschätzt wird.

11. Verfahren nach einem der vorhergehenden Ansprüche,
wobei die Regelungseinrichtung (20) ein dem Photovoltaikmodul (10) zugeordneter Wechselrichter, insbesondere ein Micro-Inverter, ist.

12. Verfahren nach einem der vorhergehenden Ansprüche,
wobei die Regelungseinrichtung (20) ein dem Photovoltaikmodul (10) zugeordneter Power Optimizer ist.

13. Photovoltaik-Einrichtung (1) umfassend ein Photovoltaikmodul (10) mit zumindest einer Perowskit-Solarzelle (11) und eine mit dem Photovoltaikmodul (10) verbundenen Regelungseinrichtung (20), wobei die Regelungseinrichtung (20) dazu ausgestaltet ist, das Photovoltaikmodul (10) zumindest zeitweilig am Punkt maximaler Leistung zu betreiben, aber die Energieentnahme zu unterbrechen, wenn die Bestrahlungsstärke einer auf das Photovoltaikmodul (10) auftreffenden elektromagnetischen Strahlung (2) einen vorbestimmten Schwellwert unterschreitet.
